# EUROPEAN PATENT APPLICATION

(11) **EP 1 067 689 A2**
(43) Date of publication of application: **10.01.2001**
(21) Application number: 00305586.0
(22) Date of filing: 03.07.2000
(51) Int. Cl.: H03J 1/00

(54) **Tuner**

(30) Priority: 08.07.1999 GB 9915917
(71) Applicant: Mitel Semiconductor Limited, Swindon, Wiltshire SN2 2QW (GB)
(72) Inventor: Thorpe, Gary Raymond, Swindon, Wiltshire SN2 3XS (GB); Herman, Fred, Swindon, Wiltshire SN3 6BU (GB)
(74) Representative: Robinson, John Stuart

(57) **Abstract**

A tuner, for example for digital satellite broadcast signals, has a receiving section (7) including a tuning arrangement in the form of a phase locked loop synthesiser (9). The output of the receiving section (7) is connected to a channel decoder (10). A system controller (11) controls the operation of the tuner via an IIC bus (12). A separate controller (15) controls the synthesiser, for example to perform frequency scanning and channel changing, upon being actuated by the system controller (12).

## Description

The present invention relates to a tuner. For example, such a tuner may be used to receive digitally encoded signals from satellites. The invention also relates to a television receiver, a video cassette recorder, a set top box and an integrated receiver decoder including such a tuner.

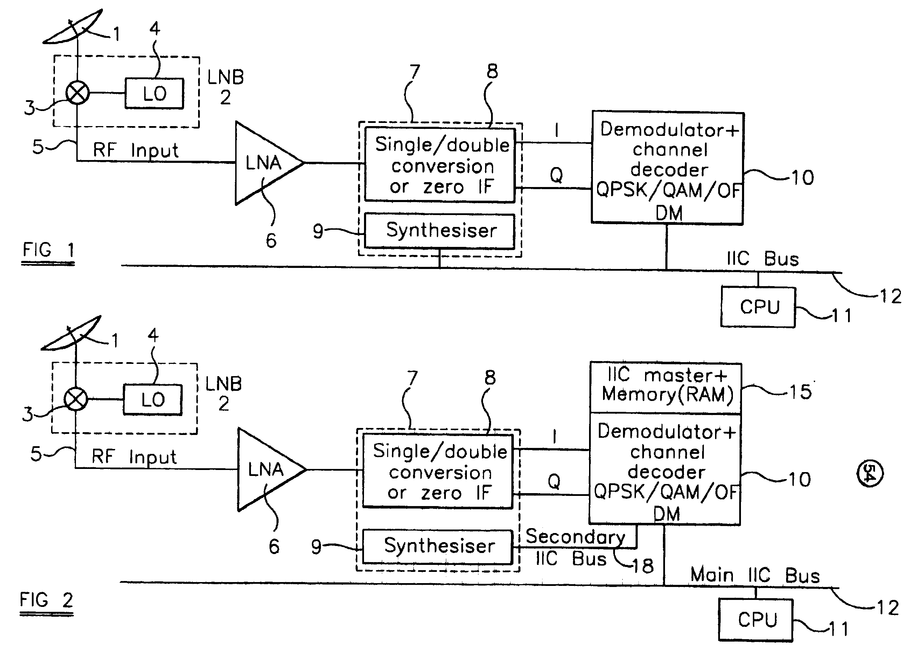

A known type of system for receiving digitally encoded television, radio and data signals is shown in Figure 1 of the accompanying drawings. The system comprises an aerial 1 in the form of a so-called "satellite dish" connected to a low noise block (LNB) 2. The LNB 2 comprises a mixer 3 and a local oscillator 4 which operate as a frequency changer for converting the signals received by the aerial 1 to a lower frequency which is suitable for transmission along a co-axial cable 5.

The output of the LNB 2 is connected via the cable 5 to the RF input of a low noise amplifier (LNA) 6 which forms part of a tuner. The output of the LNA 6 is connected to the input of a circuit arrangement 7 for converting the radio frequency signals from the LNA 6 to demodulated in-phase (I) and quadrature (Q) output signals. For example, the circuit arrangement 7 may comprise a single or double conversion superheterodyne arrangement with a suitable demodulator or a zero intermediate frequency (IF) arrangement also provided with a suitable demodulator. The arrangement 7 further comprises a frequency synthesiser 9, for example of the phase-locked loop type, which allows the tuner to be tuned so as to receive a desired channel.

The downconverted outputs I and Q are supplied to a channel demodulator and decoder 10 which demodulates and decodes the signals. For example, the tuner may be used to receive and decode quadrature phase shift keyed (QPSK) signals, quadrature amplitude modulated (QAM) signals, or orthogonal frequency division multiplexed (OFDM) signals.

The tuner further comprises a data processor which includes a central processing unit (CPU) 11 connected to an IIC bus 12. The IIC bus 12 connects the CPU 11 to various other devices and parts of the tuner, only some of which are shown in Figure 1. In particular, the bus 12 is connected to the synthesiser 9 and the decoder 10.

The signals received by the aerial 1 comprise a plurality of channels, for example occupying the L band which is from 10,700 MHz. The signals are down-converted by the LNB 2 so as to be typically in the frequency range 950 to 2150 MHz. The LNA amplifies the signals and the circuit arrangement 7 converts them into a form suitable for supplying the decoder 10. The CPU 11 controls the operation of the synthesiser 9 so as to select one of the channels for demodulation and decoding. There may, for example, be 50 to 100 channels and each of these channels may carry typically eight different programmes. The CPU 11 controls the synthesiser 9 so as to select the desired channel containing the desired programme for viewing or listening. The decoder 10 decodes the channel so as to supply the desired digital signal, which may then be subjected to further processing. For example, television signals may be digitally compressed and encoded using the MPEG encoding system and must be decoded and demultiplexed in order to supply pictures to a television apparatus, for example for use in the home.

The LNB 2 is located at or adjacent the aerial 1, which is generally located on the outside of a building. The LNB 2 is therefore subjected to a wide range of temperatures which results in drifting of the local oscillator frequency and hence of the channel frequencies of the signals supplied to the tuner. It is therefore necessary for the CPU 11 to identify which channels are present and to compensate for the effects of frequency drift of the channel frequencies.

In order for a user to be able to receive any of the channels, the tuner must determine which channels are present and must also determine certain details about the channels, such as frequency, convolution code rate, symbol rate and whether the I and Q signals are normal or inverted. The CPU 11 generates IIC control messages to perform channel acquisition and to establish the transmission details of the channels which are present.

For example, the CPU 11 may control the synthesiser 9 so as to scan the radio frequency spectrum from a predetermined minimum frequency to a predetermined maximum frequency while simultaneously searching for one or more symbol rates and convolution code rates and controlling the phase-locked loop synthesiser 9 as necessary so as to acquire all the channels and establish channel details from the decoder 10. The CPU 11 may also control the LNB 2 so as to scan the upper and lower bands while testing for signals of both horizontal and vertical polarisation.

All of the control signals for such operations are supplied via the IIC bus. Each time it is necessary to search for a channel, the decoder 10 and the synthesiser 9 must be suitably programmed. Each time a channel is found, the decoder 10 stops and waits for the CPU 11 to determine whether the channel has been successfully locked and to read the channel details. The CPU 11 must then reprogram the synthesiser 9 and restart the decoder 10 to continue the scan. This process must be repeated for every channel.

All communication is via the IIC bus, which typically requires several milliseconds for each individual communication. Thus, in known arrangements of this type, a complete scan of the input frequency band takes at best 10 minutes and may take as long as 30 minutes.

When a viewer wishes to change the channel being received, the CPU 11 has to program the synthesiser 9 for the expected channel frequency and monitor the output of the decoder 10 to establish whether the channel has been successfully locked. However, it may be necessary to re-centre the channel frequency because of frequency drift occurring, for example, in the LNB 2. Because all communications during acquisition and re-centering of a new channel are via the IIC bus 12, selecting a different channel for reception may take at best half a second. However, there is a further delay because a MPEG demultiplexer requires time to synchronise and begin decoding a new channel. In known systems, a channel change takes at best 1 second and may take as long as 3 seconds. This results in a delay which is annoying to a viewer.

GB 2 279 832 discloses an arrangement which allows a single remote controller to operate a television and cable reception system so as to avoid the need for several remote controllers to be operated in order to select all available channels. An add-on box receives signals from the remote controller and supplies these to the television or to a cable channel selection apparatus forming part of the cable network. The add-on box has a microprocessor which responds to the remote controller commands and supplies signals via an infrared link to the television for selecting, among other things, the channel to be received. The microprocessor also supplies signals along the local cable to another microprocessor which controls a tuner.

GB 2 262 419 discloses an arrangement which allows a video recorder to select a cable channel for recording when using the "timed recording" mode of operation. The VCR has a microprocessor which supplies signals for controlling selection in a "cable box" of the appropriate channel frequency.

According to a first aspect of the invention, there is provided a tuner as defined in the appended claim 1.

Further aspects of the invention are defined in the appended claim 18 to 21.

Preferred embodiments of the invention are defined in the other appended claims.

It is thus possible to provide a tuner in which frequency band scanning times and channel changing times can be substantially reduced, for example by an order of magnitude in the case of scanning. The complexity of, for example, software for a system controller may therefore be reduced and the traffic on, for example, an IIC bus may also be reduced.

The invention will be further be described, by way of example, with reference to the accompanying drawings, in which:
Figure 1 is a block schematic diagram of a known type of satellite receiving system;
Figure 2 is a block schematic diagram of a satellite receiving system including a tuner constituting an embodiment of the invention; and
Figures 3 to 5 are flow charts illustrating operation of the tuner shown in Figure 2.

Like reference numerals refer to like parts throughout the drawings.

The tuner shown in Figure 2 differs from that shown in Figure 1 in that a separate controller 15 is provided for controlling operation of the synthesiser 9. The controller 15 may be in the form of an IIC bus master with the appropriate memory, such as random access memory (RAM). The controller 15 relieves the system controller including the CPU 11 of responsibility for controlling tuning, scanning and channel acquisition by performing all of these functions independently of the CPU 11 when instructed to do so. The controller 15 does not make use of the main IIC bus 12 to control the synthesiser 9 but is instead connected directly to the control input of the synthesiser 9 and to the decoder 10, with which it may be integrated in a single integrated circuit. For example, the controller 15 may comprise a programmed data processor or a state machine.

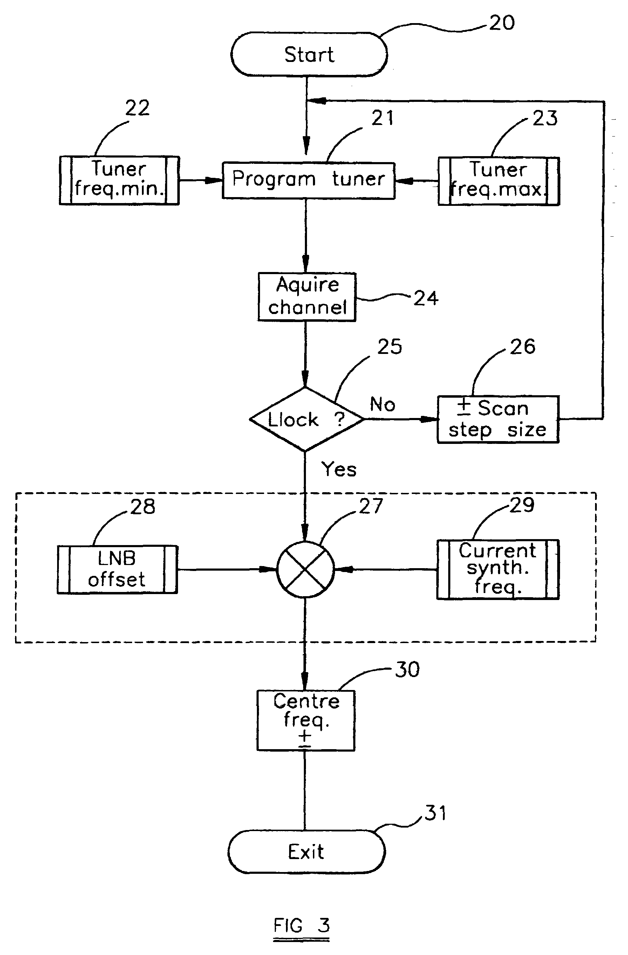

Figure 3 illustrates the operation of the controller 15 when it has been instructed by the CPU 11 to perform a frequency scan in order to detect all available channels in the input frequency range to the tuner. The scan starts at a step 20 and, at a step 21, the controller 15 controls the synthesiser 9 so as to tune the tuner to the lowest (or highest) frequency within the scan range. The tuner minimum and maximum frequencies are stored as illustrated at 22 and 23. The decoder 10 attempts to acquire the selected channel at a step 24 and, at a step 25, the controller 15 determines whether the channel has been "locked" by monitoring the locked or unlocked condition of the decoder 10. If a channel has not been acquired, the controller 15 instructs the synthesiser in a step 26 to increment (or decrement) the tuning frequency by a predetermined step size and control returns to the step 21. Thus, the steps 21 and 24 to 26 are repeated until a channel is aquired.

A step 27 computes the channel centre frequency by adding a stored LNB offset 28 to the current synthesiser frequency 29. The channel centre frequency is then centered in a step 30. Figure 3 illustrates the scan finishing at a step 31 but, in practice, the whole routine illustrated in Figure 3 is repeated until the whole frequency band has been scanned.

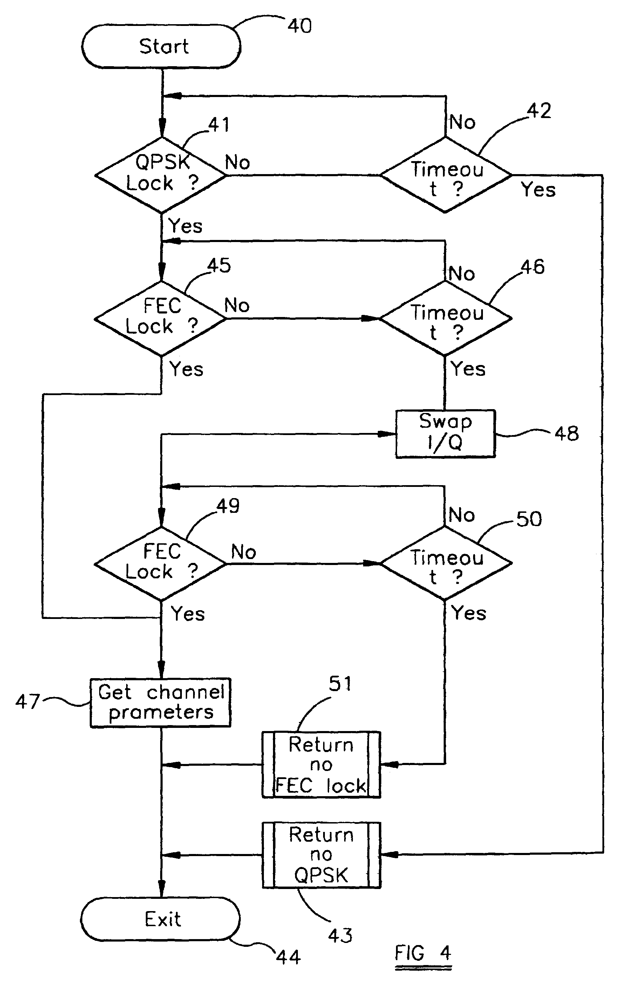

Figure 4 illustrates the channel acquisition step 24 in more detail. Acquisition starts at 40 and, in a step 41, the controller 15 checks whether the decoder (assumed to be of the QPSK type) has been able to lock onto a signal. If not, a step 42 checks whether a predetermined time has passed. If not, control returns to the step 41. However, if the time period has passed, a step 43 indicates that no lock has been achieved and the routine exits at a step 44.

If the step 41 determines that the decoder 10 has achieved lock, the controller 15, in a step 45, checks whether the decoder 10 has achieved forward error correction (FEC) lock. If not and if another predetermined time delay has not ended (step 46), control returns to the step 45. If FEC lock has been achieved, control passes to a step 47, in which the controller 15 extracts the required channel parameters before exiting the routine at 44.

If the step 45 is unable to establish FEC lock in the available time, a step 48 swaps the I and Q signals and passes control to a step 49, which is identical to the step 45. If FEC lock is achieved, the step 47 is performed. However, if no FEC lock is achieved in the time allowed in a step 50, the absence of FEC lock is indicated at a step 51 and the routine ends, again by indicating that a channel has not been acquired.

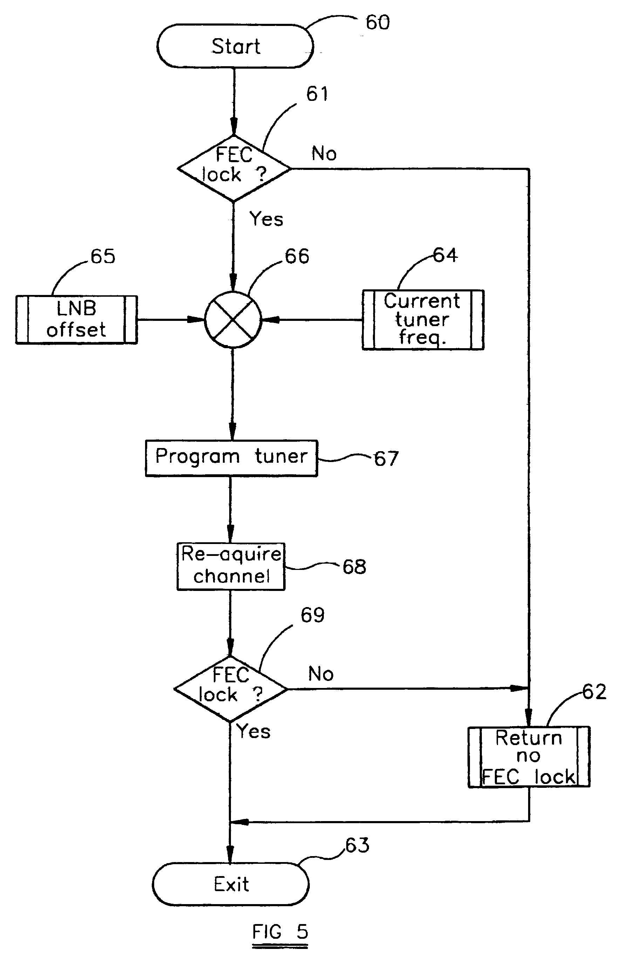

The step 30 is illustrated in more detail in Figure 5. The routine starts at 60 and a step 61 determines whether FEC lock has been achieved in the same way as the steps 45 and 49. If not, a step 62 which is identical to the step 51 is performed and the routine ends at 63. If lock is established, the current tuner frequency 64 and the LNB offset 65 are added together in a step 66 and are supplied by the controller 15 to the synthesiser 9 for programming the tuner in a step 67. An attempt is made to reacquire the channel in a step 68 and, if successful as determined in a step 69, the routine finishes. If unsuccessful, the step 62 is performed.

The use of the controller 15 which is separate from the system controller including the CPU 11 and the IIC bus 12 allows such a frequency scan to be performed at much greater speed than in the known tuner shown in Figure 1. Communication among the controller 15, the synthesiser 9 and the decoder 10 during such a frequency scan is performed totally independently of the CPU 11 and the bus 12. Such a scan may therefore be performed in a time period as short as 1 minute. Each time a channel is acquired and its parameters are established, the parameters including the frequency may be supplied to the system controller including the CPU 11. Alternatively, if sufficient memory is available in the controller 15, the data for all the acquired channels may be stored in the controller 15 and then supplied to the system controller at the end of the frequency scan.

The synthesiser 9 is controlled exclusively by the controller 15 via a secondary IIC bus 18. Thus, when a channel is selected, for example by a viewer who wishes to watch a programme in a different channel from that currently being received, the controller 15 receives a control signal from the system controller to actuate a channel change. The system controller supplies the previously stored frequency of the desired channel (or a value representing this) to the controller 15 which then controls the synthesiser 9 to tune the tuner to the desired channel. The controller 15 determines from the decoder whether the channel has been correctly acquired and, if not, varies the frequency of the synthesiser 9 until the channel is correctly decoded i.e. QPSK and FEC lock are achieved. The controller 15 then compares the new channel frequency with the stored channel frequency supplied by the system controller and calculates a new LNB offset. This is supplied to the system controller which may then either change the LNB offset value or add the offset to all of the stored channel frequencies, in which case the LNB offset does not need to be added when another channel is selected.

With the known arrangement illustrated in Figure 1, it may take typically half a second in order to retune and centre the tuner so as to receive the desired channel. In addition, when receiving compressed television signals of the MPEG type, the MPEG demultiplexer typically requires about half a second to synchronise and begin decoding the desired program in the newly selected channel. Thus, with known systems of the type shown in Figure 1, the shortest time interval between initiating a channel change and viewing the new picture is about one second but can be as long as three seconds in less good systems. This is very irritating to the viewer.

With the arrangement illustrated in Figure 2, retuning and centering can be performed typically in 50 milliseconds which is (almost) imperceptible to the viewer. The time for a channel change can therefore be reduced by about 450 milliseconds and, by using a fast MPEG demultiplexer, the total time to change channels can be reduced to about half a second.

By using the controller 15 for exclusively controlling the synthesiser 9, during both scanning and channel changing operations, delays can be substantially reduced. Frequency scanning can, for example, take place when the receiving system is in a standby mode so as not to interrupt use of the system. The system controller is relieved of the software required to perform scanning and channel changing, the need to poll the status of the decoder 10, the need to establish the channel lock status and the need to reprogram the synthesiser 9. This saves a great deal of time and reduces the software complexity of the system controller. Further, there is a substantial reduction in IIC traffic on the bus 12 between the system controller and the decoder 10.

## Claims

1. A tuner comprising a main controller (11) connected to a main bus (12) for controlling operation of the tuner and a tuning arrangement including a synthesiser (9), characterised by a subsidiary controller (15) connected to the synthesiser (9) via a subsidiary bus (18) for exclusively controlling the synthesiser (9), the subsidiary controller (15) being connected to the main bus (12) and being actuated by the main controller (11) to control the synthesiser (9) to perform a tuning operation.

2. A tuner as claimed in claim 1, characterised in that the main controller (11) is arranged to actuate the subsidiary controller (15) in response to a request to receive a desired channel.

3. A tuner as claimed in claim 2, characterised in that the subsidiary controller (15) is arranged to tune the tuning arrangement so as to receive the desired channel and to compare the frequency of the desired channel with a stored frequency of the desired channel so as to determine an offset.

4. A tuner as claimed in claim 3, characterised in that the subsidiary controller (15) is arranged to supply the offset to the main controller (11), which is arranged to store the offset.

5. A tuner as claimed in claim 4, characterised in that the main controller (11) is arranged, when actuating the subsidiary controller (15), to supply to the subsidiary controller (15) a value representing the sum of the stored frequency plus the offset.

6. A tuner as claimed in claim 3, characterised in that the subsidiary controller (15) is arranged to supply the offset to the main controller (11), which is arranged to add the offset to the or each stored frequency.

7. A tuner as claimed in claim 6, characterised in that the main controller (11) is arranged, when actuating the subsidiary controller (15), to supply to the subsidiary controller (15) a value representing the stored frequency.

8. A tuner as claimed in any one of claims 3 to 7, characterised in that the subsidiary controller (15) is arranged to tune the tuning arrangement so as to receive the desired channel by tuning the tuning arrangement to an expected frequency of the desired channel and, if the desired channel is not correctly received, varying the tuning frequency of the tuning arrangement until the desired channel is correctly received.

9. A tuner as claimed in any one of the preceding claims, characterised in that the main controller (15) is arranged to actuate the subsidiary controller (11) to scan a frequency band for the presence of channels.

10. A tuner as claimed in claim 9, characterised in that the subsidiary controller (15) is arranged to:
(a) tune the tuning arrangement to one end of the frequency band;
(b) if a channel is received, identify the channel and store the tuning frequency against a channel identifier;
(c) move the tuning frequency of the tuning arrangement towards the other end of the frequency band; and
(d) repeat (b) and (c) until the other end of the frequency band is reached.

11. A tuner as claimed in claim 9 or 10, characterised in that, upon completion of the scanning, the subsidiary controller (15) is arranged to supply the stored tuning frequencies and channel identifiers to the main controller (11).

12. A tuner as claimed in claim 10, characterised in that, upon identification of each channel, the subsidiary controller (15) is arranged to supply the stored tuning frequency and channel identifier to the main controller (11).

13. A tuner as claimed in claim 8, 10 or 12 or in claim 11 when dependent on claim 12, characterised by a decoder (10) for decoding channel signals, the subsidiary controller (15) being arranged to detect whether a channel is received by monitoring the operation of the decoder (10).

14. A tuner as claimed in claim 13, characterised in that the subsidiary controller (15) and the decoder (10) are formed in a single integrated circuit.

15. A tuner as claimed in any one of the preceding claims, characterised in that the main controller (11) comprises a programmed data processor.

16. A tuner as claimed in claim 15, characterised in that the data processor (11) is connected to an IIC bus (12).

17. A tuner as claimed in any one of the preceding claims, characterised in that the subsidiary controller (15) comprises a programmed data processor.

18. A television receiver characterised by a tuner as claimed in any one of the preceding claims.

19. A video cassette recorder characterised by a tuner as claimed in any one of claims 1 to 17.

20. A set top box characterised by a tuner as claimed in any one of claims 1 to 17.

21. An integrated receiver decoder characterised by a tuner as claimed in any one of claims 1 to 17.
